# EUROPÄISCHE PATENTANMELDUNG

(11) **EP 3 214 477 A2**
(43) Veröffentlichungstag der Anmeldung: **06.09.2017**
(21) Anmeldenummer: 17153069.4
(22) Anmeldetag: 25.01.2017
(51) Int. Cl.: G02B 19/00, G02B 27/09, G02B 27/14, H01S 5/40

(54) **VORRICHTUNG ZUR FORMUNG VON LASERSTRAHLUNG**

(30) Priorität: 15.02.2016 DE 102016102591
(71) Anmelder: LIMO Patentverwaltung GmbH & Co. KG, 44319 Dortmund (DE)
(72) Erfinder: Bagschik, Klaus, 53125 Bonn (DE)
(74) Vertreter: Basfeld, Rainer

(57) **Zusammenfassung**

Vorrichtung zur Formung von Laserstrahlung (2), umfassend ein erstes Array (7) von optischen Elementen zur Ablenkung und/oder Abbildung und/oder Kollimation der Laserstrahlung (2), das eine Mehrzahl von in einer ersten Richtung (X) nebeneinander angeordneten optischen Elementen aufweist, sowie ein zweites Array (8) von optischen Elementen zur Ablenkung und/oder Abbildung und/oder Kollimation der Laserstrahlung (2), das eine Mehrzahl von in der zweiten Richtung (Y) nebeneinander angeordneten optischen Elementen aufweist, wobei die optischen Elemente mindestens eines der Arrays (7, 8) Spiegelelemente (9, 10) sind.

## Beschreibung

Die vorliegende Erfindung betrifft eine Vorrichtung zur Formung von Laserstrahlung gemäß dem Oberbegriff des Anspruchs 1.

Definitionen: In Ausbreitungsrichtung der Laserstrahlung meint mittlere Ausbreitungsrichtung der Laserstrahlung, insbesondere wenn diese keine ebene Welle ist oder zumindest teilweise divergent ist. Mit Laserstrahl, Lichtstrahl, Teilstrahl oder Strahl ist, wenn nicht ausdrücklich anderes angegeben ist, kein idealisierter Strahl der geometrischen Optik gemeint, sondern ein realer Lichtstrahl, wie beispielsweise ein Laserstrahl mit einem Gauß-Profil oder einem Top-Hat-Profil, der keinen infinitesimal kleinen, sondern einen ausgedehnten Strahlquerschnitt aufweist. Licht soll nicht nur den sichtbaren Spektralbereich, sondern auch den infraroten und ultravioletten Spektralbereich bezeichnen.

Eine Vorrichtung der eingangs genannten Art ist beispielsweise aus der WO 2015/091392 A1 bekannt. Beim der darin beschriebenen Vorrichtung dient zur Formung der Laserstrahlung ein transparentes Bauteil, das auf seiner Eintrittsfläche und seiner Austrittsfläche jeweils ein Array aus Zylinderlinsen aufweist. Die aus der Austrittsfläche austretende Laserstrahlung wird von dem Bauteil in eine Lichtleitfaser eingekoppelt. Dabei begrenzen die Eintrittswinkel der Randstrahlen die Effizienz der Vorrichtung. Zudem sind Beschichtungen erforderlich, die über einen großen Winkelbereich eine gute Transmission erzielen. Durch die Wahl von hoch brechenden Gläsern können zwar die Randwinkel kleiner werden. Gleichzeitig sinkt aber der nutzbare Wellenlängenbereich eines gegebenen Designs.

Das der vorliegenden Erfindung zugrunde liegende Problem ist die Schaffung einer Vorrichtung der eingangs genannten Art, bei der auch mit niedrig brechendem Glas eine hohe Koppeleffizienz erreicht werden kann.

Dies wird erfindungsgemäß durch eine Vorrichtung der eingangs genannten Art mit den kennzeichnenden Merkmalen des Anspruchs 1 erreicht. Die Unteransprüche betreffen bevorzugte Ausgestaltungen der Erfindung.

Gemäß Anspruch 1 ist vorgesehen, dass die optischen Elemente mindestens eines der Arrays Spiegelelemente sind. Dabei kann vorgesehen sein, dass die Spiegelelemente des ersten und/oder des zweiten Arrays voneinander separiert sind oder übergangslos ineinander übergehen. Es soll also auch eine nicht unterbrochene reflektierende Fläche als Array von Spiegelelementen angesehen werden können. Dabei sind die Grenzen der Spiegelelemente unter Umständen nur gedachte Linien.

Es besteht die Möglichkeit, dass eine brechende Fläche der Vorrichtung des Stands der Technik durch eine reflektierende Fläche oder eine brechende und eine reflektierende Fläche ersetzt wird. Mit "Fläche" kann dabei ein optisches Element der Vorrichtung - wie beispielsweise die Einkoppeloptik für einen Emitter - gemeint sein. Im ersten Fall ist der Koppler über einen erweiterten Wellenlängenbereich einsetzbar.

Es besteht beispielsweise die Möglichkeit, dass die Laserstrahlungen der Emitter durch eine Planfläche in die Vorrichtung eintreten und jeweils von einer speziell auf den einzelnen Emitter angepassten, internen Hohlfläche (an dieser Stelle ist die Vorrichtung von außen konvex) reflektiert und dabei kollimiert und beispielsweise um 90° umgelenkt werden. Bei einem vollkommen reflektiven Koppler geschieht beim Austritt entsprechendes in umgekehrter Reihenfolge: Jede der Laserstrahlungen wird von einer internen Hohlfläche fokussiert und beispielsweise wieder um 90° abgelenkt bevor sie aus der Vorrichtung austritt.

Alternativ könnten die Laserstrahlungen der Emitter auf spiegelnde Hohlflächen auftreffen (beispielsweise off-axis Paraboloide), die diese zu weiteren Hohlflächen ablenken und dabei kollimieren. Die zweiten Hohlflächen fokussieren die Laserstrahlungen dann auf einen Faserkern.

Die Eintrittsflächen der Vorrichtungen müssen nicht plan sein. Die Richtung der eintretenden Laserstrahlung kann beliebig zu der austretenden Laserstrahlung orientiert sein. Es können auch mehr als zwei interne Reflektionen stattfinden.

Es kann vorgesehen sein, dass die Vorrichtung ein Bauteil umfasst, in dem die Spiegelelemente ausgebildet sind, so dass innere Reflexionen stattfinden. Dabei kann das Bauteil, in dem die Spiegelelemente ausgebildet sind, eine Eintrittsfläche und eine Austrittsfläche aufweisen, insbesondere wobei die Eintrittsfläche und/oder die Austrittsfläche gekrümmte Flächen sind.

Es besteht die die Möglichkeit, dass die Vorrichtung ein Bauteil umfasst, an dessen Außenseite das erste Array und das zweite Array angeordnet sind, wobei die Arrays von derselben Seite zugänglich sind, so dass im Rahmen einer Fertigung der Vorrichtung die Formung der Spiegelelemente von einer Seite erfolgen kann.

Es kann vorgesehen sein, dass sämtliche der optischen Elemente Spiegelelemente sind oder dass die Vorrichtung sowohl Spiegelelemente als auch Linsenelemente umfasst. Insbesondere kann die Vorrichtung mindestens ein Array, vorzugsweise zwei Arrays, von Spiegelelementen und insbesondere zusätzlich mindestens ein Array, vorzugsweise zwei Arrays, von Linsenelementen umfassen.

Die Erfindung wird unter Bezugnahme auf die beiliegenden Abbildungen näher beschrieben. Es zeigt:
- Fig. 1: eine schematische Seitenansicht einer ersten Ausführungsform einer erfindungsgemäßen Vorrichtung;
- Fig. 2: eine gegenüber Fig. 1 gedrehte Seitenansicht der Vorrichtung gemäß Fig. 1 ;
- Fig. 3: eine schematische Seitenansicht einer zweiten Ausführungsform einer erfindungsgemäßen Vorrichtung;
- Fig. 4: eine schematische perspektivische Ansicht einer dritten Ausführungsform einer erfindungsgemäßen Vorrichtung;
- Fig. 5: eine gegenüber Fig. 4 gedrehte perspektivische Ansicht der Vorrichtung gemäß Fig. 4.

In den Figuren sind gleiche oder funktional gleiche Teile oder Lichtstrahlen mit gleichen Bezugszeichen versehen. Weiterhin ist in einer der Figuren zur besseren Orientierung ein kartesisches Koordinatensystem eingezeichnet.

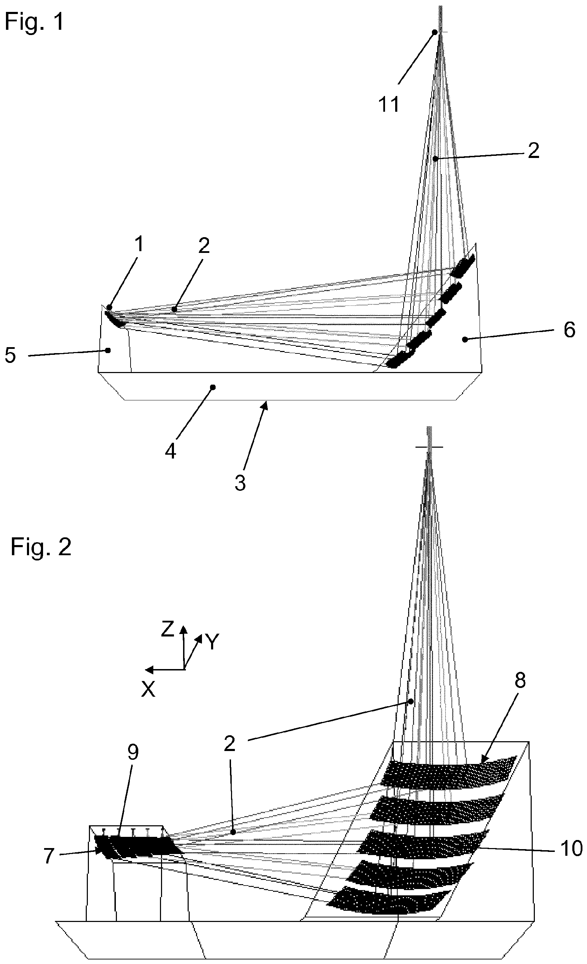

Bei der aus Fig. 1 und Fig. 2 ersichtlichen Ausführungsform sind schematisch fünf Emitter 1 eines Laserdiodenbarrens angedeutet, von denen Laserstrahlung 2 ausgeht. Die erfindungsgemäße Vorrichtung dieser Ausführungsform umfasst ein im Wesentlichen U-förmiges Bauteil 3, das eine Basis 4 und zwei auf gegenüberliegenden Seiten von der Basis 4 ausgehende Vorsprünge 5, 6 aufweist.

Auf einem jeden der Vorsprünge 5, 6 ist jeweils ein Array 7, 8 von Spiegelelementen 9, 10 angeordnet. Die Spiegelelemente 9, 10 sind dabei als reflektierende Bereiche der Außenseiten der Vorsprünge 5, 6 ausgebildet, so dass die Laserstrahlung 2 nicht in das Bauteil 3 eintritt.

Die Spiegelelemente 9, 10 sind geformte Flächen des Bauteils, die mit einer reflektierenden Beschichtung versehen sind. Die Spiegelelemente 9, 10 sind dabei auf Flächen angeordnet, die in Fig. 1 und Fig. 2 von oben zugänglich sind, so dass die Fertigung der Spiegelelemente vereinfacht wird, da zur Formung der Flächen der Spiegelelemente beispielsweise nur von einer Seite eine Pressung des zu bearbeitenden Materials erfolgen muss.

Fig. 1 und Fig. 2 zeigen, dass die Spiegelelemente 9 des ersten Arrays 9 kleiner als die Spiegelelemente 10 des zweiten Arrays 8 sind. Weiterhin zeigt sich, dass die Spiegelelemente 9, 10 beider Arrays 7, 8 als Hohlspiegel ausgebildet sind, so dass die mit einer reflektierenden Beschichtung versehene Fläche jeweils konkav ist.

Die von den Emittern 1 ausgehende Laserstrahlung 2 wird von dem ersten Array 7 von Spiegelelementen 9 zu dem zweiten Array 8 von Spiegelelementen 10 reflektiert. Von dem zweiten Array 8 wird die Laserstrahlung 2 auf die Eintrittsfläche 11 einer nicht abgebildeten Lichtleitfaser reflektiert. Dabei können die Laserstrahlungen 2 der einzelnen Emitter 1 von jeweils einem der Spiegelelemente 9 des ersten Arrays 7 kollimiert werden. Eine jede dieser kollimierten Laserstrahlungen 2 kann von jeweils einem der Spiegelelemente 10 des zweiten Arrays 8 in Richtung auf den Faserkern der Lichtleitfaser abgelenkt und auf die Eintrittsfläche 11 fokussiert werden.

Das Design gemäß Fig. 1 und Fig. 2 erlaubt eine vergleichsweise wellenlängenunabhängige Formung der Laserstrahlung 2, weil die Laserstrahlung 2 nicht durch das Bauteil 3 hindurch tritt. Allenfalls durch die Wahl der reflektierenden Beschichtung können Wellenlängenabhängigkeiten verursacht werden.

Die Spiegelelemente 9, 10 der Arrays 7, 8 können so gestaltet sein, dass sie die Laserstrahlung ablenken, wie dies in der WO 2015/091392 A1 für die Linsenarrays beschrieben ist. Die WO 2015/091392 A1 wird hiermit durch Bezugnahme zu einem Gegenstand der vorliegenden Anmeldung gemacht.

Die Spiegelelemente 9 des ersten Arrays 7 sind in einer ersten Richtung nebeneinander angeordnet, die der X-Richtung des in Fig. 2 angedeuteten kartesischen Koordinatensystems entspricht. Die Spiegelelemente 10 des zweiten Arrays 8 sind in einer zweiten Richtung nebeneinander angeordnet, die der Y-Richtung des in Fig. 2 angedeuteten kartesischen Koordinatensystems entspricht. Die zweite Richtung Y kann dabei senkrecht zur ersten Richtung X sein. Mit Z wird in diesem Koordinatensystem die mittlere Ausbreitungsrichtung der von dem zweiten Array 8 reflektierten Laserstrahlung bezeichnet.

Die Spiegelelemente 9 des ersten Arrays 7 sind in der zweiten Richtung Y versetzt zueinander angeordnet, wohingegen die Spiegelelemente 10 des zweiten Arrays 8 in der ersten Richtung X versetzt zueinander angeordnet sind.

Insbesondere entspricht die Anzahl der Spiegelelemente 9 des ersten Arrays 7 der Anzahl der Spiegelelemente 10 des zweiten Arrays 8 beziehungsweise der Anzahl der Emitter 1 des Laserdiodenbarrens. Dabei können das erste Array 7 und/oder das zweite Array 8 so gestaltet sind, dass von einem Spiegelelemente 9 des ersten Arrays 7 reflektierte Laserstrahlung genau von einem Spiegelelement 10 des zweiten Arrays 8 reflektiert wird.

Die Spiegelelemente 9 des ersten Arrays 7 sind insbesondere als Zylinderspiegel oder als zylinderähnliche Spiegel ausgebildet, wobei sich deren Zylinderachsen zumindest teilweise in X-Richtung erstrecken. Dabei ist beispielsweise die Zylinderachse des mittleren Spiegelelements 9 parallel zur X-Richtung, wohingegen die Zylinderachsen der anderen Spiegelelemente 9 mit der X-Richtung einen Winkel größer 0° beziehungsweise kleiner 0° einschließen.

Auch die Spiegelelemente 10 des zweiten Arrays 8 sind insbesondere als Zylinderspiegel oder als zylinderähnliche Spiegel ausgebildet, wobei sich deren Zylinderachsen zumindest teilweise in Y-Richtung erstrecken. Dabei ist beispielsweise die Zylinderachse des mittleren Spiegelelements 10 parallel zur Y-Richtung, wohingegen die Zylinderachsen der anderen Spiegelelemente 10 mit der Y-Richtung einen Winkel größer 0° beziehungsweise kleiner 0° einschließen.

Es besteht weiterhin die Möglichkeit, dass die Spiegelelemente 9 des ersten Arrays 7 jeweils zueinander verkippt sind, so dass jedes der Spiegelelemente 9 eine Ausrichtung aufweist, die von derjenigen der anderen Spiegelelemente 9 verschieden ist. Die Verkippung der Spiegelelemente 9 des ersten Arrays 7 kann dabei in Y-Richtung erfolgen.

Weiterhin besteht die Möglichkeit, dass die Spiegelelemente 10 des zweiten Arrays 8 unterschiedlich zueinander verkippt sind, so dass jedes der Spiegelelemente 10 eine Ausrichtung aufweist, die von derjenigen der anderen Spiegelelemente 10 verschieden ist. Die Verkippung der Spiegelelemente 10 des zweiten Arrays 8 kann dabei in X-Richtung erfolgen.

Die abgebildete Vorrichtung kann die von den Emittern 1 des nicht abgebildeten Laserdiodenbarrens ausgehende Laserstrahlung 2 formen. Insbesondere entspricht dabei die X-Richtung der Slow-Axis und die Y-Richtung der Fast-Axis des Laserdiodenbarrens.

Die Spiegelelemente 9 des ersten Arrays 7 und die Spiegelelemente 10 des zweiten Arrays 8 dienen jeweils sowohl zur Ablenkung der auf sie auftreffenden Laserstrahlung 2, als auch zur Abbildung oder Kollimation der Laserstrahlung 2.

Dabei können beispielsweise die Spiegelelemente 9 des ersten Arrays 7 die von den einzelnen Emittern 1 ausgehende Laserstrahlung 2 hinsichtlich der Fast-Axis beziehungsweise der Y-Richtung jeweils auf die Eintrittsfläche 11 der Lichtleitfaser abbilden.

Gleichzeitig bewirkt die unterschiedliche Ausrichtung der Zylinderachsen der außermittigen Spiegelelemente 9 des ersten Arrays 7, dass die von diesen ausgehende Laserstrahlung 2 in X-Richtung zur optischen Achse hin abgelenkt wird und auf die Spiegelelemente 10 des zweiten Arrays 8 auftrifft. Zusätzlich bewirken die jeweils unterschiedlichen Verkippungen der Spiegelelemente 9 des ersten Arrays 7, dass die von diesen ausgehende Laserstrahlung 2 von der optische Achse weg nach oben und nach unten in Y-Richtung abgelenkt wird und auf die entsprechenden Spiegelelemente 10 des zweiten Arrays 8 auftrifft.

Weiterhin können beispielsweise die Spiegelelemente 10 des zweiten Arrays 8 die von den einzelnen Emittern 1 ausgehende Laserstrahlung 2 hinsichtlich der Slow-Axis beziehungsweise der X-Richtung jeweils auf die Eintrittsfläche 11 der Lichtleitfaser abbilden.

Gleichzeitig bewirkt die unterschiedliche Ausrichtung der Zylinderachsen der außermittigen Spiegelelemente 10 des zweiten Arrays 8, dass die von den außermittigen Spiegelelementen 9 des ersten Arrays 7 ausgehende Laserstrahlung 2 in X-Richtung so abgelenkt wird, dass sie in einer Y-Z-Ebene verläuft (siehe Fig. 2). Zusätzlich bewirken die jeweils unterschiedlichen Verkippungen der Spiegelelemente 10 des zweiten Arrays 8, dass die von den außermittigen Spiegelelementen 9 des ersten Arrays 7 ausgehende Laserstrahlung 2 in Y-Richtung zur optischen Achse hin nach oben und nach unten abgelenkt wird und auf die Eintrittsfläche 11 der Lichtleitfaser auftrifft.

Es besteht alternativ die Möglichkeit, dass die Spiegelelemente 9 des ersten Arrays 7 und/oder die Spiegelelemente 10 des zweiten Arrays 8 die von den einzelnen Emittern 1 ausgehende Laserstrahlung 2 nicht abbilden, sondern kollimieren. Die hinsichtlich Slow-Axis und Fast-Axis kollimierte Laserstrahlung kann anschließend mittels preisgünstiger, sphärischer Optik beispielsweise auf die Eintrittsfläche 11 einer Lichtleitfaser fokussiert werden.

Anstatt einer Ausbildung als Zylinderspiegel oder zylinderähnlicher Spiegel können die Spiegelelemente 9, 10 des ersten und/oder des zweiten Arrays 7, 8 auch Krümmungen sowohl in X-Richtung als auch in Y-Richtung aufweisen. Die Oberflächen der Spiegelelemente 9, 10 können dabei beispielsweise durch gemischte Polynome beschrieben werden, bei denen nicht nur gerade Terme je Achse vorkommen, sondern auch gemischte Terme in X und Y. Auch ungerade Terme in X und Y höher als nur in der ersten Ordnung sind möglich.

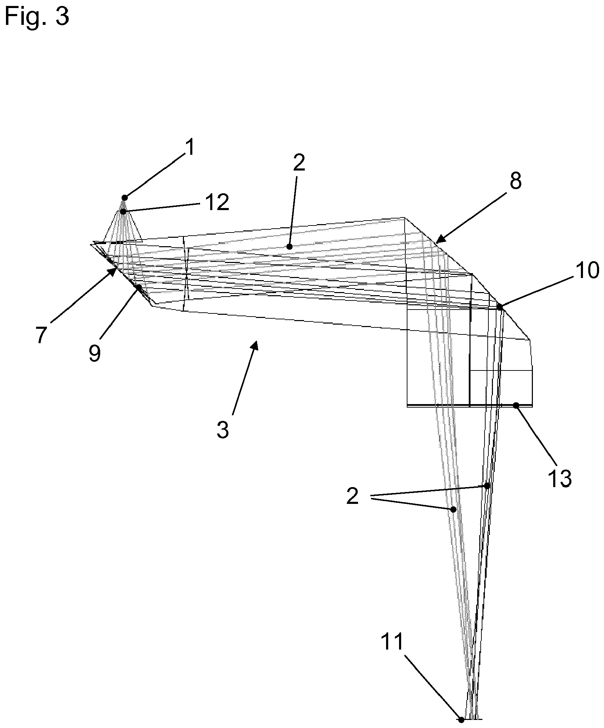

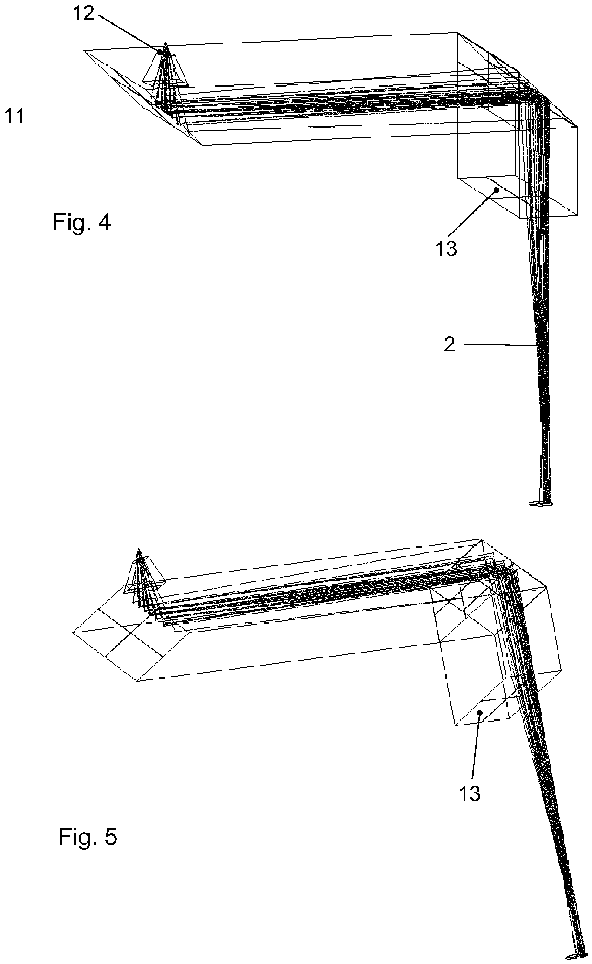

Fig. 3 einerseits sowie Fig. 4 und Fig. 5 andererseits zeigen Ausführungsbeispiele, bei denen die Spiegelelemente 9, 10 nicht an der Außenseite des Bauteils 3 sondern im Inneren des Bauteils 3 angeordnet sind, so dass innere Reflexionen stattfinden.

In Fig. 3 sind eine plane Eintrittsfläche 12 und eine ebenfalls plane Austrittsfläche 13 für die Laserstrahlung vorgesehen. Die Eintrittsfläche 12 und/oder die Austrittsfläche 13 können aber auch als gekrümmte Flächen ausgebildet sein und beispielsweise eine passende azylindrische oder asphärische Form aufweisen.

Die durch die Eintrittsfläche 12 in das Bauteil 3 eingetretene Laserstrahlung 2 wird an der das erste Array 7 bildenden Fläche, die geeignet geformt und gegebenenfalls von außen beschichtet ist, reflektiert und dabei abgelenkt sowie kollimiert. Die Spiegelelemente 9 des ersten Arrays 7 können dabei voneinander separiert sein oder aber übergangslos ineinander übergehen.

Die das zweite Array 8 bildende Fläche, die ebenfalls geeignet geformt und gegebenenfalls von außen beschichtet ist, reflektiert die Laserstrahlung 2 erneut. Diese das zweite Array 8 bildende Fläche kann bereits fokussierende oder/und strahlformende Eigenschaften aufweisen. Auch die Spiegelelemente 10 des zweiten Arrays 8 können voneinander separiert sein oder aber übergangslos ineinander übergehen.

Die das erste Array 7 und das zweite Array 8 bildenden Flächen sind insbesondere konvex geformt.

Die Laserstrahlungen treten durch die Austrittsfläche 13 aus dem Bauteil 3 aus. Bei dem in Fig. 4 und Fig. 5 abgebildeten Ausführungsbeispiel weist die Austrittsfläche 13 eine Krümmung, insbesondere eine die Fokussierung bewirkende oder unterstützende Form auf.

## Patentansprüche

1. Vorrichtung zur Formung von Laserstrahlung (2), umfassend
- ein erstes Array (7) von optischen Elementen zur Ablenkung und/oder Abbildung und/oder Kollimation der Laserstrahlung (2), das eine Mehrzahl von in einer ersten Richtung (X) nebeneinander angeordneten optischen Elementen aufweist, wobei das erste Array (7) so gestaltet ist, dass von einem ersten der optischen Elemente des ersten Arrays (7) die Laserstrahlung (2) hinsichtlich der ersten Richtung (X) und/oder hinsichtlich einer zweiten, zu der ersten Richtung (X) verschiedenen, insbesondere senkrechten, Richtung (Y) unter einem anderen Winkel abgelenkt wird als von einem zweiten der optischen Elemente des ersten Arrays (7), sowie
- ein zweites Array (8) von optischen Elementen zur Ablenkung und/oder Abbildung und/oder Kollimation der Laserstrahlung (2), das eine Mehrzahl von in der zweiten Richtung (Y) nebeneinander angeordneten optischen Elementen aufweist, wobei das zweite Array (8) so gestaltet ist, dass von einem ersten der optischen Elemente des zweiten Arrays (8) die Laserstrahlung (2) hinsichtlich der ersten Richtung (X) und/oder hinsichtlich der zweiten Richtung (Y) unter einem anderen Winkel abgelenkt wird als von einem zweiten der optischen Elemente des zweiten Arrays(8),
**dadurch gekennzeichnet, dass** die optischen Elemente mindestens eines der Arrays (7, 8) Spiegelelemente (9, 10) sind.

2. Vorrichtung nach Anspruch 1, **dadurch gekennzeichnet, dass** die Vorrichtung ein Bauteil (3) umfasst, in dem die Spiegelelemente (9, 10) ausgebildet sind, so dass innere Reflexionen stattfinden.

3. Vorrichtung nach Anspruch 2, **dadurch gekennzeichnet, dass** das Bauteil (3), in dem die Spiegelelemente (9, 10) ausgebildet sind, eine Eintrittsfläche (12) und eine Austrittsfläche (13) aufweist, insbesondere wobei die Eintrittsfläche (12) und/oder die Austrittsfläche (13) gekrümmte Flächen sind.

4. Vorrichtung nach einem der Ansprüche 1 bis 3, **dadurch gekennzeichnet, dass** die Vorrichtung ein Bauteil (3) umfasst, an dessen Außenseite das erste Array (7) und das zweite Array (8) angeordnet sind, wobei die Arrays (7, 8) von derselben Seite zugänglich sind, so dass im Rahmen einer Fertigung der Vorrichtung die Formung der Spiegelelemente (9, 10) von einer Seite erfolgen kann.

5. Vorrichtung nach einem der Ansprüche 1 bis 4, **dadurch gekennzeichnet, dass** sämtliche der optischen Elemente Spiegelelemente (9, 10) sind oder dass die Vorrichtung sowohl Spiegelelemente (9, 10) als auch Linsenelemente umfasst.

6. Vorrichtung nach einem der Ansprüche 1 bis 5, **dadurch gekennzeichnet, dass** Vorrichtung mindestens ein Array (7, 8), vorzugsweise zwei Arrays (7, 8), von Spiegelelementen (9, 10) und insbesondere zusätzlich mindestens ein Array, vorzugsweise zwei Arrays, von Linsenelementen umfasst.

7. Vorrichtung nach einem der Ansprüche 1 bis 6, **dadurch gekennzeichnet, dass** das erste Array (7) und/oder das zweite Array (8) so gestaltet sind, dass von einem optischen Element des ersten Arrays (7) reflektierte Laserstrahlung (2) oder durch ein optisches Element des ersten Arrays (7) hindurchgetretene Laserstrahlung (2) genau von einem optischen Element des zweiten Arrays (8) reflektiert wird oder durch ein optisches Element des zweiten Arrays (8) hindurch tritt, wobei insbesondere die Anzahl der optischen Elemente des ersten Arrays (7) der Anzahl der optischen Elemente des zweiten Arrays (8) entspricht.

8. Vorrichtung nach einem der Ansprüche 1 bis 7, **dadurch gekennzeichnet, dass** die optischen Elemente des ersten Arrays (7) in der zweiten Richtung (Y) versetzt zueinander angeordnet sind und/oder dass die optischen Element des zweiten Arrays (8) in der ersten Richtung (X) versetzt zueinander angeordnet sind.

9. Vorrichtung nach einem der Ansprüche 1 bis 8, **dadurch gekennzeichnet, dass** die optischen Elemente des ersten Arrays (7) und/oder die optischen Elemente des zweiten Arrays (8) als Zylinderspiegel oder als Zylinderlinsen oder als zylinderähnliche Spiegel oder Linsen ausgebildet sind.

10. Vorrichtung nach Anspruch 9, **dadurch gekennzeichnet, dass** mindestens eine der Zylinderachsen der Zylinderspiegel oder der Zylinderlinsen oder der zylinderähnlichen Spiegel oder Linsen des ersten Arrays (7) unter einem Winkel ungleich 0° und ungleich 180°, insbesondere unter einem Winkel von 90°, zu mindestens einer der Zylinderachsen der Zylinderachsen der Zylinderspiegel oder der Zylinderlinsen oder der zylinderähnlichen Spiegel oder Linsen des zweiten Arrays (8) ausgerichtet ist.

11. Vorrichtung nach einem der Ansprüche 9 oder 10, **dadurch gekennzeichnet, dass**
- die Zylinderachsen der Zylinderspiegel oder der Zylinderlinsen oder der zylinderähnlichen Spiegel oder Linsen des ersten Arrays (7) entweder parallel zu der ersten Richtung (X) sind oder einen Winkel von weniger als 45°, vorzugsweise weniger als 35°, insbesondere weniger als 25° mit der ersten Richtung (X) einschließen und/oder dass
- die Zylinderachsen der Zylinderspiegel oder der Zylinderlinsen oder der zylinderähnlichen Spiegel oder Linsen des zweiten Arrays (8) entweder parallel zu der zweiten Richtung (Y) sind oder einen Winkel von weniger als 45°, vorzugsweise weniger als 35°, insbesondere weniger als 25° mit der zweiten Richtung (Y) einschließen.

12. Vorrichtung nach einem der Ansprüche 9 bis 11, **dadurch gekennzeichnet, dass**
- die Zylinderachsen von mindestens zwei der Zylinderspiegel oder der Zylinderlinsen oder der zylinderähnlichen Spiegel oder Linsen des ersten Arrays (7) einen Winkel größer 0° und kleiner 25°, vorzugsweise einen Winkel größer 0° und kleiner 15°, insbesondere einen Winkel größer 0° und kleiner 10° miteinander einschließen und/oder dass
- die Zylinderachsen von mindestens zwei der Zylinderspiegel oder der Zylinderlinsen oder der zylinderähnlichen Spiegel oder Linsen des zweiten Arrays (8) einen Winkel größer 0° und kleiner 25°, vorzugsweise einen Winkel größer 0° und kleiner 15°, insbesondere einen Winkel größer 0° und kleiner 10° miteinander einschließen.

13. Vorrichtung nach einem der Ansprüche 1 bis 12, **dadurch gekennzeichnet, dass** die Vorrichtung zur Formung der von einem Laserdiodenbarren oder einem Stack von Laserdiodenbarren ausgehenden Laserstrahlung dienen kann, wobei die erste Richtung (X) der Slow-Axis und die zweite Richtung (Y) der Fast-Axis entspricht oder wobei die zweite Richtung (Y) der Slow-Axis und die erste Richtung (X) der Fast-Axis entspricht.

14. Vorrichtung nach Anspruch 13, **dadurch gekennzeichnet, dass**
- mindestens eine der Zylinderspiegel oder der Zylinderlinsen oder der zylinderähnlichen Spiegel oder Linsen des ersten Arrays (7) derart ausgebildet ist, dass sie die von einem Emitter des Laserdiodenbarrens oder des Stacks von Laserdiodenbarren ausgehende Laserstrahlung hinsichtlich der zweiten Richtung (Y) auf die Eintrittsfläche einer Lichtleitfaser abbilden oder hinsichtlich der zweiten Richtung (Y) kollimieren kann und/oder dass
- mindestens eine der Zylinderspiegel oder der Zylinderlinsen oder der zylinderähnlichen Spiegel oder Linsen des zweiten Arrays (8) derart ausgebildet ist, dass sie die von einem Emitter des Laserdiodenbarrens oder des Stacks von Laserdiodenbarren ausgehende Laserstrahlung hinsichtlich der ersten Richtung (X) auf die Eintrittsfläche einer Lichtleitfaser abbilden oder hinsichtlich der ersten Richtung (X) kollimieren kann.

15. Vorrichtung nach einem der Ansprüche 1 bis 14, **dadurch gekennzeichnet, dass** mindestens eines, insbesondere sämtliche, der optischen Elemente des ersten Arrays (7) und/oder dass mindestens eines, insbesondere sämtliche, der optischen Elemente des zweiten Arrays (8) sowohl hinsichtlich der ersten Richtung (X), als auch hinsichtlich der zweiten Richtung (Y) gekrümmt sind, und/oder dass mindestens eines, insbesondere sämtliche, der optischen Elemente des ersten Arrays (7) und/oder dass mindestens eines, insbesondere sämtliche, der optischen Elemente des zweiten Arrays (8) als Freiformflächen ausgebildet sind.
